# EUROPEAN PATENT APPLICATION

(11) **EP 4 841 675 A1**
(43) Date of publication of application: **18.11.2026**
(21) Application number: 25175932.0
(22) Date of filing: 13.05.2025
(51) Int. Cl.: H01L 23/48, H01L 23/544

(54) **METHOD OF BONDING ONE OR MORE DONOR SUBSTRATES TO AN ACCEPTOR SUBSTRATE**

(71) Applicant: ASML Netherlands B.V., 5500 AH Veldhoven (NL)
(72) Inventor: BANINE, Vadim Yevgenyevich, 5500 AH Veldhoven (NL); RENKENS, Michael Jozefa Mathijs, 5500 AH Veldhoven (NL); DEKKERS, Jeroen, 5500 AH Veldhoven (NL)
(74) Representative: ASML Netherlands B.V.

(57) **Abstract**

The invention concerns a method of bonding one or more donor substrates to an acceptor substrate. The method comprises: applying thermal conditioning to adjust a temperature of one or more target areas of the acceptor substrate relative to other areas of the acceptor substrate. The thermal conditioning is configured to at least partially compensate for a distortion of the acceptor substrate associated with bonding of a donor substrate to the acceptor substrate.

## Description

### TECHNICAL FIELD

The present disclosure relates generally to a method of bonding one or more donor substrates to an acceptor substrate, a bonding system, and computer program comprising instructions.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in die placement and alignment (e.g., improvements in heterogeneous integration) lead to improvements in IC manufacturing and integration abilities.

### SUMMARY

According to an embodiment, there is provided a method of bonding one or more donor substrates to an acceptor substrate. The method comprises: applying thermal conditioning to adjust a temperature of one or more target areas of the acceptor substrate relative to other areas of the acceptor substrate. The thermal conditioning is configured to at least partially compensate for a distortion of the acceptor substrate associated with bonding of a donor substrate to the acceptor substrate.

According to an embodiment, there is provided a computer program comprising instructions configured to control a semiconductor bonding system to perform the method.

According to an embodiment, there is provided a bonding system configured to perform the method.

According to an embodiment, there is provided a bonding system for bonding one or more donor substrates to an acceptor substrate. The semiconductor bonding system comprising a thermal conditioning system configured to adjust a temperature of one or more target areas of the acceptor substrate relative to other areas of the acceptor substrate, to at least partially compensate for a distortion of the acceptor substrate associated with bonding of a donor substrate to the acceptor substrate.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 is a schematic diagram illustrating different potential types of distortion (e.g., deformation and/or misalignment) that may be present in a substrate prior to bonding.
Figure 4A-C are schematic diagrams illustrating: an acceptor substrate, without distortion, prior to bonding of donor substrates; the acceptor substrate with distortion due to bonding of a first donor substrate; and the acceptor substrate with a subsequently bonded second donor substrate, which is subject to placement error due to the distortion.
Figure 5A-D are schematic diagrams illustrating: an acceptor substrate with distortion due to bonding of a first donor substrate; the target position for placement of a second donor substrate being subject to placement error due to the distortion; heating the position of the first donor substrate to compensate for the distortion; and the acceptor substrate with a subsequently bonded second donor substrate, which is subject to less placement error due to the compensation for the distortion.
Figure 6A-C are schematic diagrams illustrating heating of areas of an acceptor substrate adjacent a target position at which a donor substrate is to be bonded.
Figure 7A-B are schematic diagrams illustrating systems for heating target positions on an acceptor substrate and placing donor substrates by a moveable stage with recesses.
Figure 8 is a block diagram of an example computer system, according to an embodiment.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

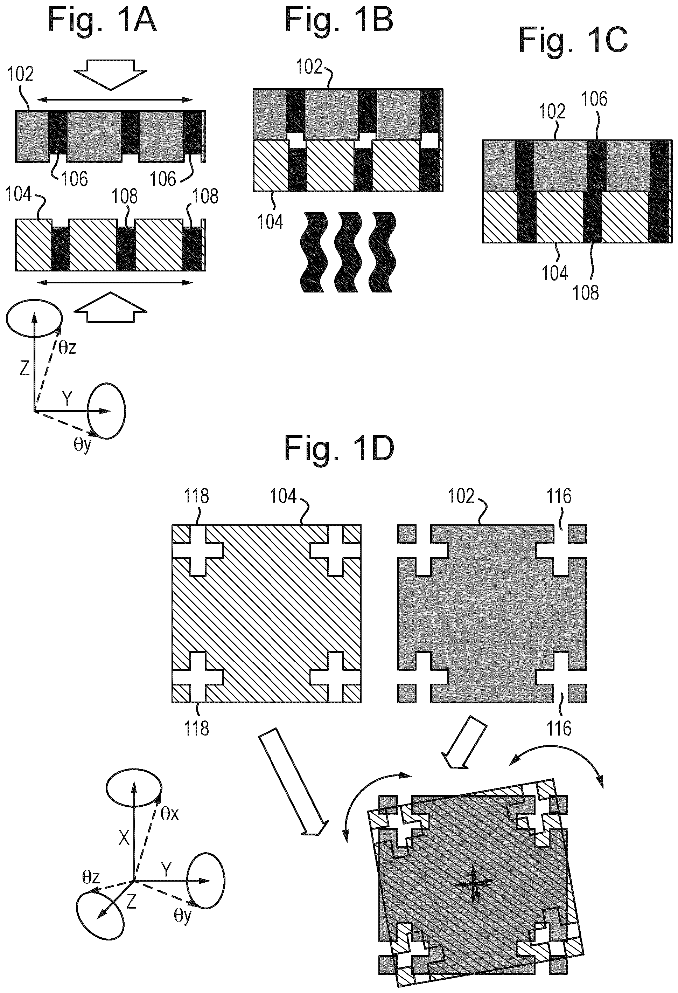

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1 A, the donor die 102 and the target die 104 may be brought together along the z-axis, while the position of the donor die 102 or the target die 104 may be adjusted in the x-y plane (e.g., perpendicular to the z-axis of approach). As shown in Figure IB, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

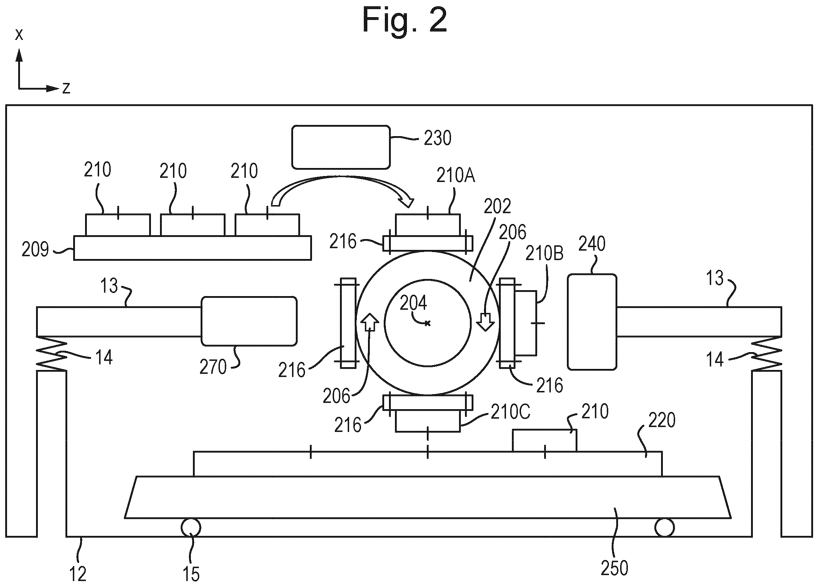

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 210A-210D using support stage 202. The support stage 202 is substantially circular in the x-z plane, with a longitudinal axis 204 along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has die acceptors 216. The placement of the die acceptors 216 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces. The die acceptors 216 are capable of accepting donor dies, such as the donor dies 210A- 210D.

The support stage 202 may be controllably moved in a direction 206 about the longitudinal axis 204. The direction 206 is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis 204. The support stage 202 may move continuously or intermittently. For example, the support stage 202 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

A first position, such as corresponding to the position depicted for the donor die 210A, may correspond to placement of die in die acceptors 216 of the support stage 202. The donor die 210A may be placed on the die acceptor 216 by a pick and place element 230. The pick and place element 230 may place the donor die 210A on the support stage 202 on the die acceptor 216 based on alignment information, based on positional information of the support stage 202, etc. The pick and place element 230 may place the donor die 210A on the support structure at a given position relative to the die acceptor 216. For example, the pick and place element 230 may center the donor die 210A relative to the die acceptor 216. The pick and place element 230 may have intrinsic error or inaccuracy.

The second position, such as corresponding to the position depicted for the donor die 210B, may correspond to measurement of the position of the die in recesses (e.g., of the donor die 210B relative to the die acceptor 216) of the support stage 202. The position (e.g., location) of the donor die 210B may be measured by a location measurement element 240. The location measurement element 240 may measure an actual position of the donor die 210B, in relative (such as relative to the die acceptor 216) or absolute terms (such as in distances from an origin point on the support stage 202, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an inplane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202.

Once the position of the donor die 210B is measured, the support stage 202 may move (e.g., in the direction 206), so that the donor die 210B occupies the position of the donor die 210C which may be a third position of the support stage 202. The third position of the support structure will now be described with reference to the donor die 210C.

The third position, such as corresponding to the position depicted for the donor die 210C, may correspond to placement of the die on a corresponding target, for example, an acceptor substrate 220. The acceptor substrate 220 may comprise one or more target dies which may be sequentially contacted by a donor die during various movements of the support stage 202.

The acceptor substrate 220 is supported by the support structure 250. The donor die 210C may be placed on the acceptor substrate 220 by motion of the support stage 202 towards the acceptor substrate 220. Alternatively or additionally, the support structure 250 may also be a moveable structure operable to bring the donor die 210C and the acceptor substrate 220 into contact.

Once the donor die 210C is placed on the acceptor substrate 220, the support stage 202 and the support structure 250 may operate (individually or in concert) to place additional donor dies on the acceptor substrate 220. For example, the support structure 250 may move in the negative z-direction so that another part of the acceptor substrate 220 is proximate to the support stage 202 and a donor die (for example, the donor die 210B after rotation of the support stage 202) may be placed on the acceptor substrate 220. The relative motion of the support stage 202 and the support structure 250 may occur in any appropriate direction. A direction of gravity is not depicted, but the placement of the donor die 210C on the acceptor substrate 220 may experience gravitation effects. For example, the placement of the donor die 210C on the acceptor substrate 220 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 202 shown in Figure 2 is for die placement. The stage 202 is for placing dies 210, for example onto an acceptor substrate 220. The stage 202 comprises an actuator. The actuator is configured to cause the stage 202 to accept the dies 210 from pick & place element 230 and subsequently transport the dies 210 to alignment sensor 240 and finally place the dies 210 on the acceptor substrate 220.

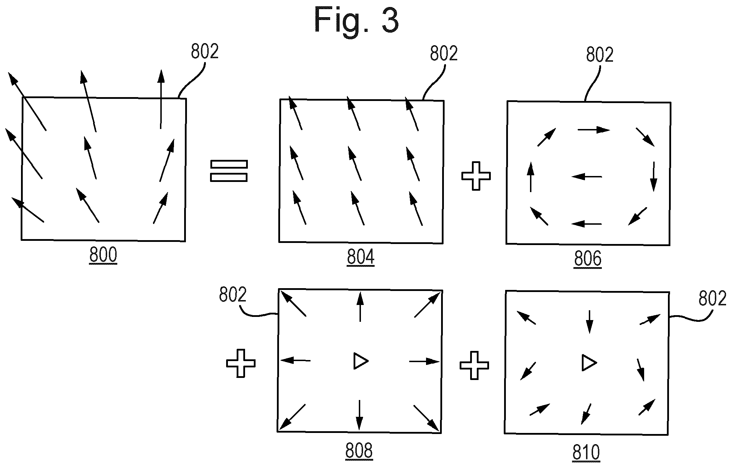

Figure 3 illustrates different potential types of deformation, misalignment, and/or other distortion 800 that may be present in a substrate 802 (e.g., a first substrate 208 and/or second substrate 230) prior to bonding. As shown in Figure 3 substrate 802 (e.g., a die, wafer, and/or other substrates) may have some amount of distortion 800 made up of translational distortion 804 (or misalignment), rotational distortion 806 (or misalignment), magnification distortion 808, and/or other residual distortion 810 (or misalignments) that needs to be corrected prior to bonding. Note that translation and rotation may not technically be distortions, but free body movements or misalignments. These can be corrected by moving a substrate relative to a carrier wafer, for example. However, for the purposes of this patent application, it can be useful to think of these generally in terms of distortion, in that the present systems and methods are configured to move one or more features from a first position (e.g., a distorted or unexpected or misaligned position, which can have many causes) to a second, expected position, as described herein.

Typical distortion for a 10mm die of 50 µm thickness (as one representative example) is on the order of about 300nm. The four components of the distortion described above - translation, rotation, magnification, and residue - may have mean values of about 200nm, 20nm, 150n, and 20nm, respectively (in this example). With typical bonding process controls, only translational distortion (e.g., from about 200nm to about 20nm) and rotational distortion (e.g., from about 3 mRad to about 3 nRad) can be corrected. This correction may be accomplished by actuation of donor die holders and/or actuation of a wafer stage, for example.

Bonding of donor substrates (e.g., dies) to an acceptor substrate (e.g., a sample or wafer) can result in distortion of the acceptor substrate. The distortion of the acceptor substrate may influence the accuracy of placement of subsequent donor substrates. For example, deformation due the bonding of a donor substrate may result in distortions, for example of an order of tens of nanometers, locally in a region adjacent to the region of the bonding, on the acceptor substrate.

In some known processes, a rectangular grid is provided on the acceptor substrate to aid in identifying potential locations (e.g., die stations) at which the donor substrates may be bonded to the acceptor substrate. The grid is most commonly used for calibration purposes, prior to bonding any donor substrates on the acceptor substrate. It is then commonly assumed that the grid does not change as the donor substrates are bonded to the acceptor substrate. However, this assumption of the unchanging grid might be not correct, particularly for systems with otherwise high positioning accuracies due to the deformation induced by bonded donor substrates onto the acceptor substrate. Therefore, as systems/tools for bonding of donor substrates onto acceptor substrates become capable of ever more accurate placement, the relative influence of distortion of the acceptor substrate, associated with bonding of donor substrates, becomes more significant on the overall accuracy of donor substrate placement.

As explained above, the bonding of donor substrates to the acceptor substrate may result in distortion of the acceptor substrate. This distortion of the acceptor substrate may also distort the grid on the surface of the acceptor substrate to which the donor substrates are to be bonded. This can introduce a problem of correct positioning of subsequent donor substrates on the acceptor substrate. In particular, unless action is taken to account for this issue, the subsequent donor substrates will be placed based on the original position of the grid, prior to bonding of any donor substrates to the acceptor substrate. In practice, due to distortion of the acceptor substrate, the grid will be distorted such that there will be a difference between the intended placement area of the subsequent donor substrate and the actual position on the grid at which the subsequent donor substrate is placed. This difference may therefore be considered to represent an error in placement of the subsequent donor substrates.

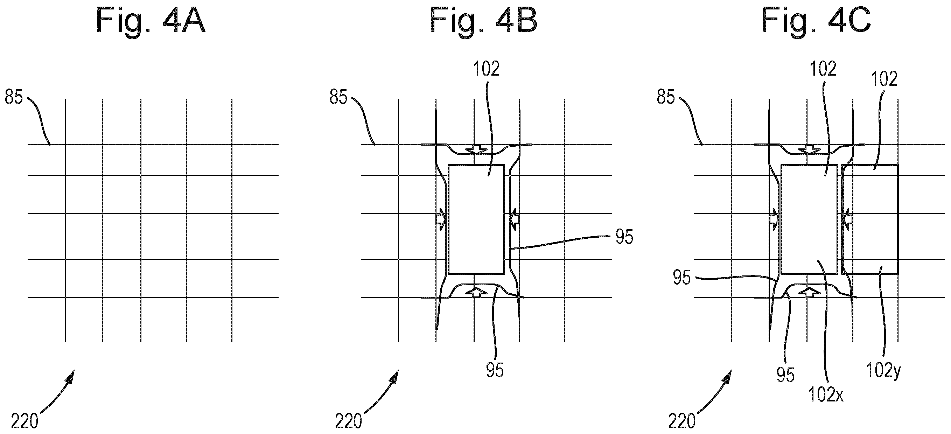

Figures 4A-C are schematic diagrams illustrating an acceptor substrate 220 without and with donor substrates 102 bonded thereon. Figure 4A shows the acceptor substrate 220, without distortion of the grid 85, prior to bonding of donor substrates 102. Figure 4B shows the acceptor substrate 220 with distortion 95 of the grid 85 due to bonding of a preceding donor substrate 102x. In particular, the bonding of the preceding donor substrate 102x onto an acceptor substrate 220 causes a compression stress inside the acceptor substrate 220. This compression stress results in local deformation 95 in the area surrounding the bonded preceding donor substrate 102x. Figure 4C shows the acceptor substrate 220 with a subsequently bonded subsequent donor substrate 102y, which is subject to placement error due to the distortion 95 of the grid 85. In other words, the expected position of the grid, based on the grid 85 on the acceptor substrate 220, of Figure 4A, prior to bonding of any donor substrates 102 does not match the actual position of the grid 85, in a region adjacent to the bonded preceding donor substrate 102x, with distortion 95 after bonding of the preceding donor substrate 102x. Thus, as shown in Figure 4C, if the subsequent donor substrate 102y is placed based on the expected position of the grid 85, there will be a placement error for the subsequent donor substrate 102y. The placement error may be quantified based on a difference between an intended position of the subsequent donor substrate 102y on the acceptor substrate 220 and the actual position of the donor substrates 102y on the acceptor substrate 220 (i.e., a difference between the undistorted grid 85 and the grid with distortion 95).

Further distortion may be caused directly from a deformed shape of the donor substrate 102, in addition to any distortion caused by the process of bonding the donor substrate 102 to the acceptor substrate 220.

The influence of distortion of the acceptor substrate 220 may be reduced by applying particular methods of bonding the donor substrates 102 to the acceptor substrate 220. In particular, thermal conditioning may be applied to adjust a temperature of one or more target areas 121 of the acceptor substrate 220 relative to other areas of the acceptor substrate 220. The thermal conditioning is configured to at least partially compensate for a distortion of the acceptor substrate 220 associated with bonding of a donor substrate 102 to the acceptor substrate 220.

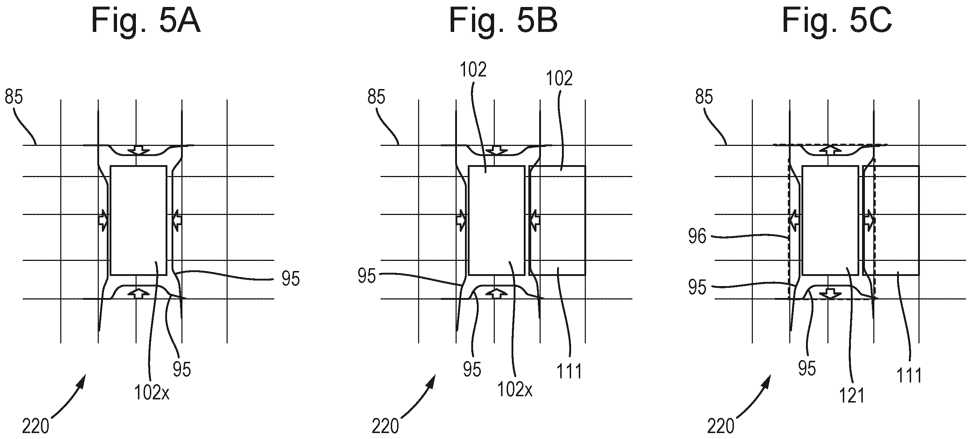

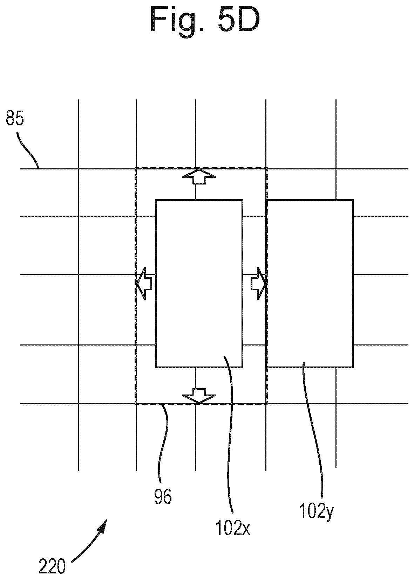

Figures 5A-D are schematic diagrams illustrating an acceptor substrate 220 before and after thermal conditioning to compensate for distortion caused by bonding of a preceding donor substrate 102x to the acceptor substrate 220. Figure 5A shows the acceptor substrate 220 with distortion 95 of the grid 85 due to bonding of the preceding donor substrate 102x. Figure 5B shows the acceptor substrate 220 with the preceding donor substrate 102x bonded thereon. Figure 5B further shows a target position 111 for placement of a subsequent donor substrate 102y. In Figure 5B, the target position 111 is subject to placement error due to the distortion 95 of the grid 85. Figure 5C shows the acceptor substrate 220 with the preceding donor substrate 102x bonded thereon. Figure 5C further shows a target area 121 for applying thermal conditioning to compensate, at least partially and optionally fully, for the distortion. In the arrangement of Figure 5C, the target area 121 corresponds to the position on the acceptor substrate 220 at which the preceding donor substrate 102x has been bonded to the acceptor substrate 220. Figure 5C shows the corrected grid 96 after the thermal conditioning has been applied to compensate for the distortion 95 of the grid 85 due to bonding of the preceding donor substrate 102x. Figure 5D shows the acceptor substrate 220 with a subsequent donor substrate 102y placed on the acceptor substrate 220 at a position adjacent to the preceding donor substrate 102x. The subsequent donor substrate 102y is associated with a smaller placement error due to the compensation for the distortion. In particular, the subsequent donor substrate 102y has been placed in accordance with the corrected grid 96, which is associated with less distortion and therefore smaller placement errors than with full distortion 95 of the grid 85 as was demonstrated by Figure 4B prior to thermal conditioning at the target area 121.

The method may be carried out using a bonding tool for bonding a plurality of donor substrates 102 to an acceptor substrate 220. The bonding tool may be comprised within a bonding system for bonding a plurality of donor substrates 102 to an acceptor substrate 220. The bonding system comprises a thermal conditioning system configured to adjust a temperature of one or more target areas 121 of the acceptor substrate 220 relative to other areas of the acceptor substrate 220. The temperature adjustment is configured to at least partially compensate for a distortion of the acceptor substrate 220 associated with bonding of a donor substrate 102 to the acceptor substrate 220. The thermal conditioning system may be comprised in the bonding tool. Alternatively, the bonding tool and the thermal conditioning system may be separate apparatus comprised within the bonding system.

The bonding tool may, optionally, comprise a moveable stage with recesses, such as described above in reference to Figure 2. Alternatively, the bonding tool may have a different arrangement to that shown in Figure 2. For example, the bonding tool may optionally comprise one or more robotic arms configured to place the donor substrates 102 at the respective placement areas.

The thermal conditioning may comprise increasing a temperature of the one or more target areas 121 relative to the temperature of the other areas of the acceptor substrate 220. In this way, a tensile stress may be induced in the acceptor substrate 220 which may compensate for a compressive stress caused by the bonding of a donor substrate 102 to the acceptor substrate 220. The distortion of the acceptor substrate 220 in a region adjacent to, or surrounding, the one or more target areas 121, may therefore be reduced. The thermal conditioning may be applied, for example, by heating the one or more target areas 121. Alternatively, the thermal conditioning may be applied by cooling areas other than the one or more target areas 121 of the acceptor substrate 220.

The distortion, which is at least partially compensated for by the thermal conditioning, may be at least partially associated with compression stress induced in the acceptor substrate 220 during the process of bonding the donor substrate 102 to the acceptor substrate 220. Alternatively, or additionally, the distortion may comprise errors associated with one or more donor substrates 102 having a distorted (e.g., non-flat) shape being bonded to the acceptor substrate 220. In this way, the distortion of the donor substrate 102 may result in a respective distortion of the acceptor substrate 220 in a region of the placement area of the donor substrate 102 on the acceptor substrate 220. The distortion may comprise distortion due to a scaling error and/or a magnification error associated with the donor substrate 102 bonded to the acceptor substrate 220.

To bond the donor substrate 102 to the acceptor substrate 220, the opposing (i.e., facing) surfaces of the donor substrate 102 to the acceptor substrate 220 must make contact. Any air between the donor substrate 102 to the acceptor substrate 220 is preferably removed, for example by applying pressure (e.g., to "squeeze" out any air bubbles). In other words, this results in air pressure near the location of the bond. During bonding, the acceptor substrate 220 or the donor substrate 102 may be clamped in place, while the other of the acceptor substrate 220 or the donor substrate 102 is released/unclamped. The air pressure near the bond can result in deformation/strain in the unclamped substrate in the bonding area. This deformation can result in the bonded substrate having a stretched shape. This may be a stretching in a single direction, corresponding to a scaling error, or in multiple directions, corresponding to a magnification error.

In the method described above with reference to Figure 5A-D, the preceding donor substrate 102x is bonded to the acceptor substrate 220 at a placement area corresponding to a target area 121. In other words, the thermal conditioning may be applied to change, preferably increase, a temperature of the acceptor substrate 220 in a placement area, at which a donor substrate 102 has been bonded, or will be bonded. In the method described above with reference to Figure 5A-D, the thermal conditioning is be applied to change a temperature of the acceptor substrate 220 in a placement area at which the preceding donor substrate 102x has been bonded. In other words, in the method of Figure 5A-D, the thermal conditioning is applied after the preceding donor substrate 102x is bonded to the acceptor substrate 220.

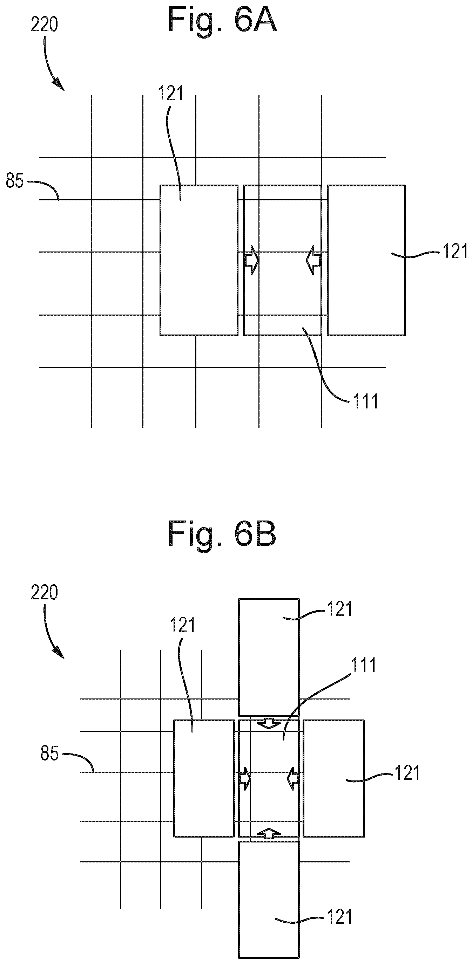

In another method (e.g., as described below with reference to Figure 6A-C) the thermal conditioning may optionally be applied before the donor substrate 102x is bonded to the acceptor substrate 220. In situations where the thermal conditioning is applied prior to bonding of the donor substrate 102 to the acceptor substrate 220, the bonding of the donor substrate 102 to the acceptor substrate 220 is preferably performed simultaneously, or within a predetermined time period after, the thermal conditioning. In other words, the thermal conditioning is preferably applied within a predetermined time period prior to bonding of the donor substrate 102 to the acceptor substrate 220. In this way, the thermal conditioning may more effectively compensate for stress induced in the acceptor substrate 220 by the bonding process. If the time period between applying the thermal conditioning, and bonding the corresponding donor substrate 102 to the acceptor substrate 220 is too great, any pre-stress induced by the thermal conditioning may have subsided such that it does not as greatly compensate for the stress due to bonding. Consequently, if the time period is too great the distortion may be less fully compensated and thus there may be a greater placement error in placing the donor substrate 102 than if the time period were shorter. The predetermined time period may be up to 2 seconds, preferably between 0.02 seconds and 1 seconds, more preferably between 0.03 seconds and 0.5 seconds, yet more preferably between 0.04 seconds and 0.3 seconds, and yet more preferably between 0.05 seconds and 0.2 seconds. The predetermined time period may be selected based on thermal properties of the material of the acceptor substrate 220. For example, a predetermined time period of up to 0.2 seconds may be preferable for a silicon acceptor substrate 220.

A size of the target area is preferably equal to, or within a predetermined range of, a footprint area of the donor substrate 102 to be placed at the corresponding placement area. In other words, the thermal conditioning is intended to be applied in a target area which preferably at least includes at least 25% of the footprint area of the donor substrate 102, and preferably between 50 % and 100% of the footprint area. The target area may optionally be up to 50% greater than the footprint area of the donor substrate 102 to be placed at the corresponding placement area, preferably up to 25% greater, more preferably up to 10% greater.

The thermal conditioning may be configured to increase an average temperature in the one or more target areas 121 by a threshold temperature increase (optionally referred to as a predetermine amount) compared to the average temperature of the non-target areas of the acceptor substrate 220. The threshold temperature increase may, for example, be between 0.2°C and 25°C, preferably between 0.5°C and 20°C, more preferably between 1°C and 15°C, yet more preferably between 2°C and 10°C, optionally between 3°C and 5°C. In the method of Figures 5A-D, the thermal conditioning may be applied substantially uniformly (e.g., within +/- 0.1 to 0.5 °C) across the target area 121. Alternatively, in some scenarios, it may be desirable to apply the thermal conditioning non-uniformly across the target area 121.

As described above, for example in reference to Figures 5A-D, distortion of the acceptor substrate 220 may be compensated for by thermal conditioning applied to a target area 121 corresponding to the placement area at which a preceding donor substrate 102x has been or will be bonded. Additionally, or alternatively, thermal conditioning may be applied to a target area 121 adjacent to the placement area 111 at which a donor substrate 102 has been or will be bonded to the acceptor substrate 220.

Figure 6A-C are show heating of areas of an acceptor substrate 220 at target areas 121 adjacent a placement area 111 at which a donor substrate 102 is to be bonded. In other words, in the arrangements of each of Figures 6A-C, one or more target areas 121 are subject to thermal conditioning. The thermal conditioning of each target area 121 may provide correction of the grid 85 in a direction indicated by the arrows in Figures 6A-C. A donor substrate 102 will be bonded to the acceptor substrate 220 at a placement area 111 adjacent to, or within a predetermined range of, one or more of the one or more target areas 121.

As shown in Figures 6A-C, the one or more target areas 121 may comprise a plurality of target areas 121. There may be at least two target areas 121 adjacent the placement area 111. As shown in Figures 6A-C, the at least two target areas 121 may include two target areas 121 on opposing sides of the placement area 111. In the arrangement of Figure 6A, there are only two target areas 121, and the two target areas 121 are disposed on opposing sides of the placement area 111. Such an arrangement may be particularly suitable for compensating scaling errors.

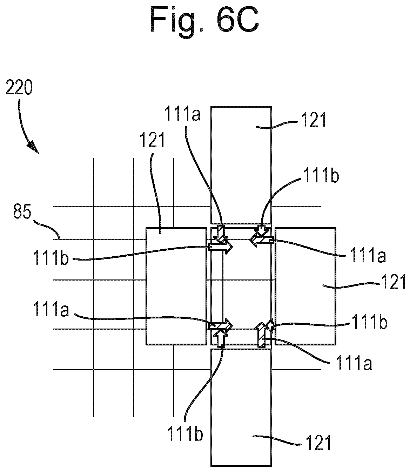

In the arrangements of Figure 6B and 6C, the target areas are adjacent all sides of the placement area 111, in a plane of the acceptor substrate 220. In the particular examples of Figures 6B and 6B, there are four target areas 121, including two sets of two target areas 121 disposed on opposing sides of the placement area 111.

In the arrangement of Figure 6B (as indicated by the single arrows) the thermal conditioning is configured to be applied substantially uniformly across each target area 121. In other words, each target area 121 may be heated such that a change in temperature and/or an absolute temperature reached is substantially uniform across the target area 121. For example, a uniformly applied thermal conditioning may result in a temperature variation across the target area 121 of less than or equal to a maximum threshold temperature variation. The maximum threshold temperature variation may be 5°C, more preferably 2°C, yet more preferably 1°C. In the arrangement of Figure 6B (as indicated by the arrows of same colour and size) the thermal conditioning is configured to be applied substantially uniformly among the plurality of target areas 121. In other words, the target areas 121 may be heated such that an average change in temperature and/or an average absolute temperature reached for each target area 121 is substantially uniform between the different target areas 121. For example, a uniformly applied thermal conditioning may result in a temperature variation between the different target areas 121 of less than or equal to the maximum threshold temperature variation. The arrangement of Figure 6B therefore corresponds to providing substantially uniform thermal conditioning on all sides of the placement area 111 (in a plane of the acceptor substrate 220). Such an arrangement may be suitable, for example for compensating for magnification errors.

In the arrangement of Figure 6C (as indicated by the multiple arrows of different size) the thermal conditioning is configured to be applied substantially non-uniformly across each target area 121. For example, as shown in Figure 6C, the larger, hatched, arrows may correspond to a region of the target area 121 having undergone greater heating than the region of the target area 121 corresponding to the smaller, unhatched, arrows. In other words, a temperature gradient may be provided across each target area 121. A target area 121 may be heated such that a change in temperature and/or an absolute temperature reached is substantially non-uniform across the target area 121. For example, a non-uniformly applied thermal conditioning may result in a temperature variation across the target area 121 of greater than or equal to a minimum threshold temperature variation. The minimum threshold temperature variation may be 5°C, more preferably 10°C, yet more preferably 15°C. The arrangement of Figure 6C therefore corresponds to providing substantially non-uniform thermal conditioning around all sides of the placement area 111 (in a plane of the acceptor substrate 220). Such an arrangement may be suitable, for example for compensating higher order aberrations (e.g., for compensation of distortion of the donor substrate 102 itself, rather than or in addition to, distortion of the acceptor substrate 220 due to the bonding process).

Alternatively, or additionally, to non-uniform thermal conditioning within one or more of the target areas 121. The thermal conditioning is optionally configured to be applied non-uniformly among the plurality of target areas 121. In other words, the target areas 121 may be heated such that an average change in temperature and/or an average absolute temperature reached for each target area 121 is substantially non-uniform between the different target areas 121. For example, a non-uniformly applied thermal conditioning may result in a temperature variation between the different target areas 121 of greater than or equal to the minimum threshold temperature variation.

A number and/or position of the one or more target areas 121 may be selected based on a determined distortion of the acceptor substrate 220 due to bonding of the donor substrate 102 at the placement area 111. For example, as described above with reference to Figure 6A, if it is determined that there is a scaling error then it may be suitable to provide thermal conditioning at target positions 121 on opposing sides of the placement area in order to compensate for the scaling error.

The distortion of the acceptor substrate 220 may be determined, for example, by measurement. In other words, the determined distortion may be determined based on a measurement of the acceptor substrate 220 after the donor substrate 102 has been bonded to the acceptor substrate 102 at the placement area 111. For example, the distortion 95 of the grid 85 on the acceptor substrate 220 may be measured. Measuring the acceptor substrate 220 has the advantage of being likely to more accurately determine the actual distortion, compared to relying on a mathematical model prediction. However, this improvement comes at the cost of decreased throughput due to the time taken to measure the acceptor substrate. For this reason, it may be desirable to measure the acceptor substrate 220 at intervals, rather than between bonding of each donor substrate 102.

During bonding of the donor substrates 102 to the acceptor substrate 220, the acceptor substrate 220 may be held in place by a clamp. The acceptor substrate 220 is preferably released from the clamp prior to measuring the acceptor substrate 220 to determine the distortion of the acceptor substrate 220. The measurement may then be taken with the acceptor substrate 220 in a released condition in which the acceptor substrate 220 is not held by the clamp. In this way, the distortion of the acceptor substrate 220 in the released condition may be determined. The acceptor substrate 220 may be returned to a clamped condition, in which the acceptor substrate 220 is held in place by the clamp for bonding of subsequent donor substrates 102 to the acceptor substrate 220.

Alternatively, or additionally, the distortion of the acceptor substrate 220 may be determined based on a mathematical model. In other words, the determined distortion may be determined based on a mathematical model of the acceptor substrate 220 and the one or more donor substrates 102. The mathematical model may be used to estimate the distortion 95 and caused by placing, and bonding, each donor substrate 102 to the acceptor substrate 220. The mathematically model may optionally be further used to simulate the influence of thermal conditioning on the acceptor substrate 220. In this way, the mathematical model may be used to inform the amount and/or nature of thermal conditioning. The mathematical model may optionally be used to simulate different amounts and/or natures of thermal conditioning to aid in determining the thermal conditioning to be applied to the real-life acceptor substrate 220.

Optionally, the mathematical model may be correlated based on the measurements taken. Additionally, or alternatively, the mathematical model may be used to estimate the distortion of the acceptor substrate 220 due to donor substrates 102 bonded to the acceptor substrate 220 during the intervals between measurements of the acceptor substrate 220.

Additionally, or alternatively, an amount and/or nature of thermal conditioning is applied may be selected based on the determined distortion. For example, as described above with reference of Figure 6B, if it is determined that there is a magnification error then it may be suitable to provide uniform thermal conditioning at target positions 121 on all sides of the placement area in order to compensate for the magnification error. Similarly, a level of heating may be selected based on the determined distortion. For example, the greater the determined distortion (e.g., based on difference to flat or expected topography of the acceptor substrate 220), a greater amount of thermal conditioning (e.g., greater temperature increase to target areas 121) may be applied compared to if the determined distortion is less.

The thermal conditioning is provided by adjusting a temperature of the acceptor substrate 220. It is preferably that the temperature is adjusted such that a temperature in the one or more target areas 121 is greater than a temperature of the other areas of the acceptor substrate 220. The thermal conditioning may be performed by reducing a temperature in areas of the acceptor substrate other than the target areas 121. In a preferred arrangement, the thermal conditioning is performed by increasing a temperature in areas of the acceptor substrate other than the target areas 121.

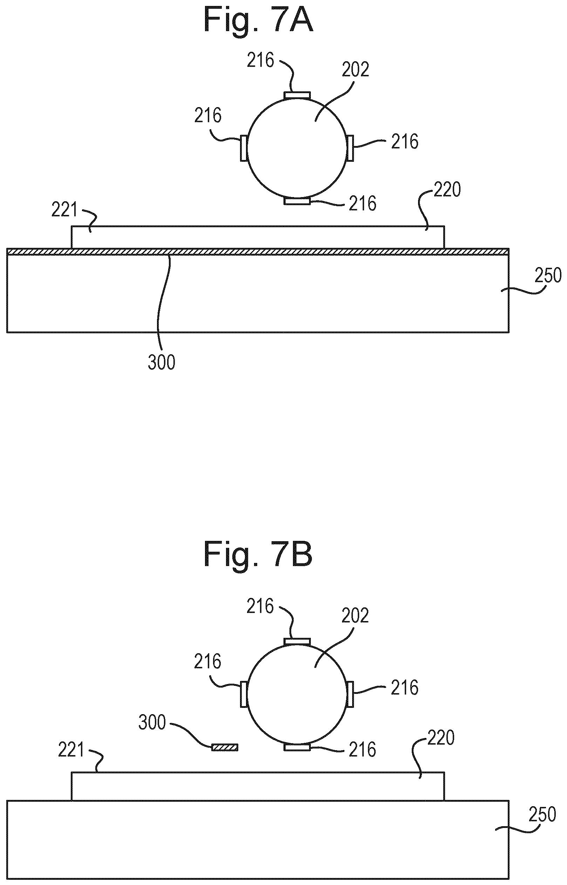

Figure 7A-B show bonding systems for placing donor substrates 102 on the acceptor substrate 220 by a moveable stage with recesses, as described above in reference to Figure 2. The bonding systems of Figures 7A and 7B each further comprise a thermal conditioning system for heating target positions 121 on an acceptor substrate 220.

In bonding systems, such as those of Figures 7A and 7B, one or more heating devices 300 are used to heat the one or more target areas 121 of the acceptor substrate 220. Alternatively, or additionally, one or more cooling devices may be provided to cool the areas other than the one or more target areas 121 of the acceptor substrate 220 in order to compensate for distortion of the acceptor substrate 220.

As shown for example in Figure 7A, the one or more heating devices 300 may be disposed on or within a substrate support 250 configured to support the acceptor substrate 220 during bonding. The one or more heating devices 300 optionally comprises a plurality of heating devices 300. The one or more heating devices 300 may extend, or be distributed, across a footprint of the acceptor substrate 220. The footprint of the acceptor substrate 220 may be an area corresponding to a majority of a first major surface 221 of the acceptor substrate 220, wherein the first major surface 221 is the surface on which the donor substrates 102 are to be bonded. The footprint of the acceptor substrate 220 may include all placement areas 111 at which donor substrates 102 may be bonded to the acceptor substrate 102. In other words, the one or more heating devices 300 may be disposed such that thermal conditioning may be simultaneously applied to one or more selected target areas 121 on the acceptor substrate 220. The one or more selected target areas 121 may include target areas 121 which are adjacent each other. Alternatively, or additionally, the one or more selected target areas 121 may include target areas 121 which are separated from each other by a distance across the surface of the acceptor substrate 220. The one or more heating devices 300 optionally comprises a heating element. Alternatively, or additionally, the one or more heating devices 300 may comprise one or more conduits configured to direct fluid of different temperatures to different areas across the footprint of the acceptor substrate 220.

The one or more heating devices 300 may be on a surface of the substrate support 250. For example, the one or more heating devices 300 may be provided on the surface of the substrate support 250, between the substrate support 250 and the acceptor substrate 220. The substrate support 250 may comprise protrusions (e.g., burls) configured to support the acceptor substrate 220. The heating elements may optionally be disposed between protrusions. Alternatively, the one or more heating devices 300 may be disposed within the substrate support 250. For example, the one or more heating devices 300 may comprise one or more conduits disposed on or within the substrate support 250 and configured to direct fluid of different temperatures to different areas across the footprint of the acceptor substrate 220.

The one or more heating devices 300, for example in the arrangement of Figure 7A and 7B, are preferably controllable such that the one or more heating devices 300 are configured to selectively heat the one or more target areas 121. In other words, the one or more heating devices 300 preferably enable a user to select one or more target areas 121 to undergo thermal conditioning, optionally simultaneously. As explained above in regard to Figure 5A-D, in some situations the target areas 121 may correspond to placement areas 111 for donor substrates 102 on the acceptor substrate 220. As explained above in regard to Figure 6A-C, in some situations the target areas 121 may be adjacent to and/or surrounding a placement areas 111 for a donor substrate 102 on the acceptor substrate 220.

As shown for example in Figure 7B, alternatively or additionally to one or more heating devices 300 on or within the substrate support 250, the one or more heating devices 300 may comprise one or more heating devices 300 disposed facing the first major surface 221 of the acceptor substrate 220. In other words, the one or more heating devices 300 may be disposed above the substrate support 250 and arranged to face the acceptor substrate 220 to heat the one or more target areas 121. The one or more heating devices 300 optionally comprises a plurality of heating devices 300 distributed over the first major surface 221 of the acceptor substrate 220. The one or more heating devices 300 may extend, or be distributed, across the first major surface 221 of the acceptor substrate 220. The one or more heating devices 300 may be configured to heat target areas 121 at any position within a region corresponding to a majority of the first major surface 221 of the acceptor substrate 220. The region of the acceptor substrate 220 may include all placement areas 111 at which donor substrates 102 may be bonded to the acceptor substrate 102. In other words, the one or more heating devices 300 may be disposed such that thermal conditioning may be simultaneously applied to one or more selected target areas 121 on the acceptor substrate 220. The one or more selected target areas 121 may include target areas 121 which are adjacent each other. Alternatively, or additionally, the one or more selected target areas 121 may include target areas 121 which are separated from each other by a distance across the surface of the acceptor substrate 220. The one or more heating devices 300 optionally comprises a heating element. Alternatively, or additionally, the one or more heating devices 300 may comprise one or more conduits configured to direct fluid of different temperatures to different areas across the footprint of the acceptor substrate 220.

In an arrangement such as that of Figure 7B, wherein one or more heating devices 300 are disposed facing the first major surface 221 of the acceptor substrate 220, one or more heating devices 300 may be configured to move relative to the acceptor substrate 220 to heat the one or more target areas 121. The one or more heating devices 300 and/or the substrate support 250 on which the acceptor substrate 220 is supported may be actuated in order to direct heat from one or more of the heating devices 300 towards the selected target area 121 on the substrate support 220.

In an arrangement such as that of Figure 7B, wherein one or more heating devices 300 are disposed facing the first major surface 221 of the acceptor substrate 220, the one or more heating devices 300 optionally comprises one or more light emitting devices (LEDs). The one or more light emitting devices may comprise an array of light emitting devices. The light emitting devices in the array are preferably distributed such that the array is configured to illuminate the first major surface 221 of the acceptor substrate 220. The light emitting diodes are preferably to selectively illuminate and heat the one or more target areas 121 on the first major surface 221.

Additionally, or alternatively, to light emitting diodes, one or more light emitting devices may comprise one or more a laser emitting devices configured to direct light and heat to the one or more target areas 121 on the first major surface 221 of the acceptor substrate 220. The laser emitting devices may optionally comprise a plurality of laser emitting devices arranged in an array facing the first major surface 221. Additionally, or alternatively, the one or more heating devices 300 may comprise one or more heating elements configured heat the one or more target areas 121 on the first major surface 221 of the acceptor substrate 220. The heating elements may optionally comprise a plurality of heating elements arranged in an array facing the first major surface 221.

The one or more heating devices 300, for example in arrangements such as shown in Figure 7A and 7B, may be configured to provide to the target areas 121 with between 0.1 and 100 W/cm², preferably between 0.5 and 50 W/cm², more preferably between 1 and 30 W/cm², yet more preferably between 5 and 30 W/cm².

A computer program may be provided to perform the above-described methods. For example, the computer program may comprise instructions configured to control a bonding tool or bonding system to perform the methods as described above in relation to the present invention.

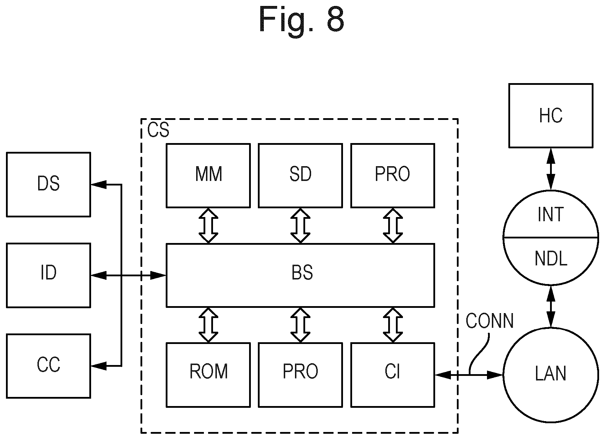

Figure 8 is a diagram of an example computer system CS that may be used for one or more of the operations described herein (e.g., one or more of the operations of method 1700 shown in Fig. 17 and/or other operations). Computer system CS may be included in and/or be similar to and/or the same as the controller(s) described above (e.g., computer system CS may form some or all of the controller(s) described above, two computer systems CS may be used to form two different controllers, etc.). Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a flat panel or touch panel display for displaying information to a computer user or observer. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, all or some of one or more operations described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" or "machine-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a network. Computer system CS can receive the data and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection CONN through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Various embodiments of the present systems and methods are disclosed in the subsequent list of numbered clauses. In the following, further features, characteristics, and exemplary technical solutions of the present disclosure will be described in terms of clauses that may be optionally claimed in any combination:
1. A method of bonding one or more donor substrates to an acceptor substrate, the method comprising: applying thermal conditioning to adjust a temperature of one or more target areas of the acceptor substrate relative to other areas of the acceptor substrate, wherein the thermal conditioning is configured to at least partially compensate for a distortion of the acceptor substrate associated with bonding of a donor substrate to the acceptor substrate.
2. The method of clause 1, wherein the thermal conditioning comprises changing a temperature of the one or more target areas relative to the temperature of the other areas of the acceptor substrate.
3. The method of clause 2, wherein changing a temperature of the one or more target areas comprises increasing the temperature of the one or more target areas.
4. The method of any preceding clause, further comprising bonding the donor substrate to the acceptor substrate at a placement area corresponding to a target area of the one or more target areas.
5. The method of clause 4, wherein a size of the target area, is equal to, or within a predetermined range of, a footprint area of the donor substrate.
6. The method of clause 4 or 5, wherein the thermal conditioning is configured to be applied substantially uniformly across the target area.
7. The method of any of clauses 1 to 3, further comprising bonding the donor substrate to the acceptor substrate at a placement area adjacent to, or within a predetermined range of, one or more of the one or more target areas.
8. The method of clause 7, wherein the one or more target areas comprise a plurality of target areas, and wherein there are at least two target areas adjacent the placement area.
9. The method of clause 8, wherein the two target areas are on opposing sides of the placement area.
10. The method of clause 7, wherein the one or more target areas comprise a plurality of target areas, and wherein the target areas are adjacent all sides of the placement area in a plane of the acceptor substrate.
11. The method of any of clauses 7 to 10, wherein the thermal conditioning is configured to be applied substantially uniformly across each target area.
12. The method of any of clauses 7 to 11, wherein the thermal conditioning is configured to be applied substantially uniformly among the plurality of target areas.
13. The method of any of clauses 7 to 10, wherein the thermal conditioning is configured to be applied non-uniformly across each target area.
14. The method of any of clauses 7 to 10 or 13, wherein the thermal conditioning is configured to be applied non-uniformly among the plurality of target areas.
15. The method of any preceding clause, wherein a number of target areas is based on a determined distortion of the acceptor substrate associated with bonding of the donor substrate at the placement area.
16. The method of any preceding clause, wherein a position of the one or more target areas relative to the placement area at which the donor substrate is bonded, is based on a determined distortion of the acceptor substrate due to bonding of the donor substrate at the placement area.
17. The method of clause 15 or 16, wherein the thermal conditioning is applied depending on the determined distortion.
18. The method of clause 17, wherein the thermal conditioning comprises heating to increase the temperature of the acceptor substrate in the one or more target areas.
19. The method of clause 17, wherein a level of heating is selected based on the amount and/or nature of the determined distortion.
20. The method of any of clauses 15 to 19, wherein the determined distortion is determined based on a mathematical model of the acceptor substrate and the donor substrate.
21. The method of any of clauses 15 to 19, wherein the determined distortion is determined based on a measurement of the acceptor substrate after the donor substrate has been bonded to the acceptor substrate at the placement area.
22. The method of any of clauses 1 to 20, wherein the thermal conditioning is applied prior to bonding of the donor substrate to the acceptor substrate.
23. The method of clause 22, wherein the thermal conditioning is applied within a predetermined time period prior to bonding of the donor substrate, wherein the predetermined time period is between 0.05 seconds and 0.5 seconds.
24. The method of any preceding clause, wherein the thermal conditioning is provided by adjusting a temperature of the acceptor substrate such that a temperature in the one or more target areas is greater than a temperature of the other areas of the acceptor substrate.
25. The method of clause 24, further comprising using one or more heating devices to heat the one or more target areas.
26. The method of clause 25, wherein the one or more heating devices are disposed on or within a substrate support configured to support the acceptor substrate during bonding.
27. The method of clause 26, wherein the one or more heating devices comprises a plurality of heating devices distributed across a footprint of the acceptor substrate, wherein the method comprises controlling the one or more heating devices to selectively heat the one or more target areas.
28. The method of any of clauses 25 to 27, wherein the one or more heating devices comprises one or more heating devices disposed facing a first major surface of the acceptor substrate, wherein the first major surface is the surface on which the donor substrate is bonded.
29. The method of clause 28, wherein the one or more heating devices comprises a plurality of heating devices distributed over the first major surface of the acceptor substrate, wherein the method comprises controlling one or more of the one or more heating devices to selectively heat the one or more target areas.
30. The method of clause 28, comprising moving the one or more heating devices over the acceptor substrate into position to heat the one or more target areas.
31. The method of any of clauses 28 to 30, wherein the one or more heating devices comprises one or more light emitting devices.
32. The method of clause 28, wherein the one or more light emitting devices comprises an array of light emitting devices distributed such that the array is configured to illuminate the first major surface of the acceptor substrate, wherein the method comprises controlling the light emitting devices in the array to selectively illuminate and heat the one or more target areas.
33. The method of clause 31 or 32, wherein the one or more light emitting devices comprises a laser emitting device or a light emitting diode.
34. The method of any preceding clause, wherein the thermal conditioning comprises adjusting the temperature of areas of the acceptor substrate such that the one or more target areas are subjected to a target temperature a predetermined amount warmer than the other areas of the acceptor substrate.
35. The method of clause 34, wherein the predetermined amount is between 0.5°C and 10°C.
36. The method of any preceding clause, wherein the distortion comprises a scaling error and/or a magnification error associated with bonding of the donor substrate to the acceptor substrate.
37. The method of any preceding clause, wherein the donor substrate is a die and the acceptor substrate is a wafer.
38. A computer program comprising instructions configured to control a semiconductor bonding system to perform the method of any preceding clause.
39. A semiconductor bonding system configured to perform the method of any of clauses 1 to 37.
40. A semiconductor bonding system for bonding one or more donor substrates to an acceptor substrate, semiconductor bonding system comprising: a thermal conditioning system configured to adjust a temperature of one or more target areas of the acceptor substrate relative to other areas of the acceptor substrate, to at least partially compensate for a distortion of the acceptor substrate associated with bonding of a donor substrate to the acceptor substrate.
41. The system of clause 40, wherein thermal conditioning system is configured to adjust a temperature of the acceptor substrate such that a temperature in the one or more target areas is greater than a temperature of the other areas of the acceptor substrate.
42. The system of clause 41, wherein the thermal conditioning system comprises one or more heating devices configured to heat the one or more target areas.
43. The system of clause 42, further comprising a substrate support configured to support the acceptor substrate during bonding, wherein the thermal conditioning system comprises one or more heating devices disposed on or within the substrate support.
44. The system of clause 43, wherein the one or more heating devices comprises a plurality of heating devices distributed across a footprint of the acceptor substrate, wherein the heating devices are controllable to selectively heat the one or more target areas.
45. The system of any of clauses 42 to 44, wherein the thermal conditioning system comprises one or more heating devices disposed facing a first major surface of the acceptor substrate, wherein the first major surface is the surface on which the donor substrate is bonded.
46. The system of clause 45, wherein the one or more heating devices comprises a plurality of heating devices distributed over the first major surface of the acceptor substrate, wherein the heating devices are controllable to selectively heat the one or more target areas.
47. The system of clause 45 or 46, wherein the one or more heating devices comprises one or more heating devices configured to move relative to the acceptor substrate to be positioned to heat the one or more target areas.
48. The system of any of clauses 45 to 47, wherein the one or more heating devices comprises one or more light emitting devices.
49. The system of clause 48, the one or more light emitting devices comprises an array of light emitting devices distributed such that the array is configured to illuminate the first major surface of the acceptor substrate, wherein the light emitting devices are controllable to selectively illuminate and heat the one or more target areas.
50. The system of clause 48 or 49, wherein the one or more light emitting devices comprises a laser emitting device or a light emitting diode.
51. The system of any of clauses 42 to 47, wherein the one or more heating devices comprises a heating element.
52. The system of any of clauses 40 to 51, wherein the thermal conditioning system is configured to adjusting the temperature of areas of the acceptor substrate such that the one or more target areas are subjected to a target temperature a predetermined amount warmer than the other areas of the acceptor substrate.
53. The system of clause 52, wherein the predetermined amount is between 0.5°C and 10°C.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the claims.

The descriptions above are intended to be illustrative, not limiting. Thus, it will be apparent to one skilled in the art that modifications may be made as described without departing from the scope of the claims.

## Claims

1. A method of bonding one or more donor substrates to an acceptor substrate, the method comprising:
applying thermal conditioning to adjust a temperature of one or more target areas of the acceptor substrate relative to other areas of the acceptor substrate,
wherein the thermal conditioning is configured to at least partially compensate for a distortion of the acceptor substrate associated with bonding of a donor substrate to the acceptor substrate.

2. The method of claim 1, wherein the thermal conditioning comprises changing a temperature of the one or more target areas relative to the temperature of the other areas of the acceptor substrate.

3. The method of claim 2, wherein changing a temperature of the one or more target areas comprises increasing the temperature of the one or more target areas.

4. The method of claim 1, further comprising bonding the donor substrate to the acceptor substrate at a placement area corresponding to a target area of the one or more target areas.

5. The method of claim 4, wherein a size of the target area, is equal to, or within a predetermined range of, a footprint area of the donor substrate.

6. The method of claim 1, wherein a number of target areas is based on a determined distortion of the acceptor substrate associated with bonding of the donor substrate at the placement area.

7. The method of claim 1, wherein a position of the one or more target areas relative to the placement area at which the donor substrate is bonded, is based on a determined distortion of the acceptor substrate due to bonding of the donor substrate at the placement area.

8. The method of claim 7, wherein the thermal conditioning is applied depending on the determined distortion.

9. The method of claim 7, wherein the determined distortion is determined based on a mathematical model of the acceptor substrate and the donor substrate.

10. The method of claim 7, wherein the determined distortion is determined based on a measurement of the acceptor substrate after the donor substrate has been bonded to the acceptor substrate at the placement area.

11. The method of claim 8, wherein the thermal conditioning is applied within a predetermined time period prior to bonding of the donor substrate, wherein the predetermined time period is between 0.05 seconds and 0.5 seconds.

12. The method of claim 1, wherein the donor substrate is a die and the acceptor substrate is a wafer.

13. A semiconductor bonding system for bonding one or more donor substrates to an acceptor substrate, semiconductor bonding system comprising:
a thermal conditioning system configured to adjust a temperature of one or more target areas of the acceptor substrate relative to other areas of the acceptor substrate, to at least partially compensate for a distortion of the acceptor substrate associated with bonding of a donor substrate to the acceptor substrate.

14. The system of claim 13, wherein thermal conditioning system is configured to adjust a temperature of the acceptor substrate such that a temperature in the one or more target areas is greater than a temperature of the other areas of the acceptor substrate.

15. The system of claim 14, wherein the thermal conditioning system comprises one or more heating devices configured to heat the one or more target areas.
